(19) **Europäisches Patentamt / European Patent Office / Office européen des brevets**

(11) **EP 2 530 048 A1**

(12) **EUROPEAN PATENT APPLICATION**

(43) Date of publication:
05.12.2012 Bulletin 2012/49

(21) Application number: 12168956.6

(22) Date of filing: 22.05.2012

(51) Int Cl.:
$C01B\ 21/06$ (2006.01) $C30B\ 7/00$ (2006.01)
$C30B\ 29/60$ (2006.01) $C09K\ 11/02$ (2006.01)
$C30B\ 29/40$ (2006.01)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 31.05.2011 JP 2011121970

(71) Applicant: Sharp Kabushiki Kaisha
Osaka-shi, Osaka 545-8522 (JP)

(72) Inventor: Ryowa, Tatsuya
Osaka-shi, Osaka 545-8522 (JP)

(74) Representative: Treeby, Philip David William et al
R.G.C. Jenkins & Co
26 Caxton Street
London
Greater London SW1H 0RJ (GB)

(54) **Semiconductor Nanoparticle Production Method, Semiconductor Nanoparticle, and Phosphor Using the Same**

(57) A method of producing a semiconductor nanoparticle of the present invention includes a core formation step of heating a first solution including group 13 element-containing fatty acid salt, a group 13 element-containing halide, and alkali metal amide to obtain a nanoparticle core made of a group 13 element-containing nitride, and a shell formation step of heating a second solution including the nanoparticle core, group 13 element-containing fatty acid salt, and alkali metal amide to obtain a semiconductor nanoparticle (10) having the nanoparticle core (11) covered with a shell layer (12) made of a group 13 element-containing nitride.

FIG.1

**Description**

This nonprovisional application is based on Japanese Patent Application No. 2011-121970 filed on May 31, 2011, with the Japan Patent Office, the entire contents of which are hereby incorporated by reference.

BACKGROUND OF THE INVENTION

Field of the Invention

The present invention relates to a method of producing a semiconductor nanoparticle, a semiconductor nanoparticle, and a phosphor employing the semiconductor nanoparticle. Specifically, the semiconductor nanoparticle is made of a group 13 element-containing nitride.

Description of the Background Art

It is known that a quantum size effect is exhibited when a semiconductor crystal particle (hereinafter, referred to as "crystallite") is reduced to a size approximately as small as an exciton Bohr radius. The quantum size effect refers to the property of electrons in a substance, when reduced in size, can no longer move freely, and the energy of the electrons in such a state is not arbitrary and only a specific value can be obtained. For example, the wavelength of light generated from a crystallite having the size of approximately the exciton Bohr radius becomes shorter as the size becomes smaller (refer to C. B. Murray et al., (Journal of the American Chemical Society), 1993, 115, pp. 8706-8715 (Non-Patent Literature 1)).

Further, Japanese National Patent Publication No. 2008-544013 (Patent Literature 1) discloses group 13 group 15 semiconductor nanoparticle phosphor materials of a core-shell structure having the energy state rendered stable at the surface of the semiconductor nanoparticle to improve light emission efficiency by the coverage of the semiconductor nanoparticle with a compound of larger band gap energy.

SUMMARY OF THE INVENTION

However, a semiconductor nanoparticle of a core-shell structure is disadvantageous in that the light emission efficiency of the phosphor material is degraded under a state where the surface of the core and/or shell is rendered uneven, or where a defect caused by lattice mismatch occurs at the core-shell interface, or where the core surface is not completely covered with the shell.

The present invention is directed to providing a method of producing a semiconductor nanoparticle of a core-shell structure having high light emitting intensity, a semiconductor nanoparticle having high light emitting intensity, and a phosphor employing such a semiconductor nanoparticle.

The present invention relates to a method of producing a semiconductor nanoparticle including a core formation step of heating a first solution including group 13 element-containing fatty acid salt, a group 13 element-containing halide, and alkali metal amide to obtain a nanoparticle core made of a group 13 element-containing nitride; and a shell formation step of heating a second solution including the nanoparticle core, group 13 element-containing fatty acid salt, and alkali metal amide to obtain a semiconductor nanoparticle having the nanoparticle core covered with a shell layer made of a group 13 element-containing nitride.

The method of producing a semiconductor nanoparticle of the present invention may further include a fatty acid salt synthesis step of causing a reaction between a group 13 element-containing halide and fatty acid, for example, to obtain fatty acid salt used in the core formation step and/or shell formation step.

In the method of producing a semiconductor nanoparticle of the present invention, preferably the first solution further includes a modification organic compound. The modification organic compound is preferably a thiol compound, more preferably hexadecanethiol.

In the method of producing a semiconductor nanoparticle of the present invention, the group 13 element-containing halide used in the core formation step is preferably gallium iodide and/or indium iodide.

In the method of producing a semiconductor nanoparticle of the present invention, the alkali metal amide is preferably sodium amide.

In the method of producing a semiconductor nanoparticle of the present invention, the fatty acid salt preferably includes a chain hydrocarbon group having a carbon number greater than or equal to 8. Furthermore, the fatty acid salt in the first solution and the fatty acid salt in the second solution are preferably different compounds. Moreover, the fatty acid salt in the second solution preferably includes a fatty acid group of a carbon number less than the carbon number of the fatty acid salt in the first solution.

The present invention relates to a semiconductor nanoparticle including a crystallite containing the bonding of a group 13 atom and a nitrogen atom, and group 13 element-containing fatty acid salt. The nitrogen atom of the crystallite and the group 13 atom of the group 13 element-containing fatty acid salt are chemically bound.

Preferably, the semiconductor nanoparticle of the present invention further includes a thiol compound chemically bound to the group 13 element of the crystallite.

The present invention also relates to a phosphor employing the semiconductor nanoparticle set forth above.

A method of producing a semiconductor nanoparticle of the present invention is directed to a semiconductor nanoparticle including a nanoparticle core and a shell layer covering the nanoparticle core. Since the core formation step and shell formation step are carried out in the presence of group 13 element-containing fatty acid salt, a semiconductor nanoparticle having high light emitting intensity can be produced. The present invention can also provide a semiconductor nanoparticle having high heat emitting intensity. Furthermore, a phosphor having high light emission efficiency and superior in reliability can be provided employing a semiconductor nanoparticle of the present invention.

The foregoing and other objects, features, aspects and advantages of the present invention will become more apparent from the following detailed description of the present invention when taken in conjunction with the accompanying drawing.

BRIEF DESCRIPTION OF THE DRAWING

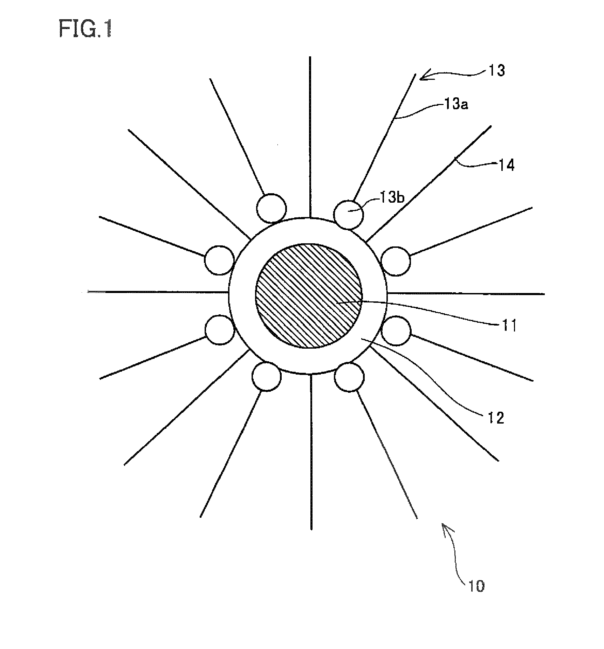

Fig. 1 schematically represents an example of a basic structure of a semiconductor nanoparticle produced by the production method of the present invention.

DESCRIPTION OF THE PREFERRED EMBODIMENTS

[Method of Producing Semiconductor Nanoparticle]

A method of producing a semiconductor nanoparticle of the present invention includes a core formation step [2] of heating a first solution including group 13 element-containing fatty acid salt, a group 13 element-containing halide, and alkali metal amide to obtain a nanoparticle core made of a group 13 element-containing nitride; and a shell formation step [3] of heating a second solution including the nanoparticle core, group 13 element-containing fatty acid salt, and alkali metal amide to obtain a semiconductor nanoparticle having the nanoparticle core covered with a shell layer made of a group 13 element-containing nitride. Preferably, the first solution further includes a modification organic compound.

For the group 13 element-containing fatty acid salt included in the first solution and second solution, there is exemplified a compound synthesized by a fatty acid salt synthesis step [1] of causing a reaction between a group 13 element-containing halide and fatty acid to obtain fatty acid salt. In the present invention, the fatty acid salt synthesis step [1] may be carried out before the core formation step [2]. Each step will be described in detail hereinafter.

[1] Fatty Acid Salt Synthesis Step

In the fatty acid salt synthesis step, reaction between fatty acid including an aliphatic group and a group 13 element-containing halide is caused to form a group 13 element-containing fatty acid salt. The aliphatic group is preferably a chain hydrocarbon group.

The fatty acid includes, but is not particularly limited to, butanoic acid, pentanoic acid, hexanoic acid, heptanoic acid, octanoic acid, nonanoic acid, decanoic acid, dodecanoic acid, tetradecanoic acid, pentadecanoic acid, hexadecanoic acid, heptadecanoic acid, octadecanoic acid, nonadecanoic acid, eicosanoic acid, or the like, for example. Particularly, fatty acid including a chain hydrocarbon group having a carbon number greater than or equal to 8 is preferably used in the core formation step [2] and shell formation step [3] that will be described afterwards by virtue of favorable solubility and highest yield. In other words, fatty acid including a chain hydrocarbon group of a carbon number greater than or equal to the carbon number of dodecanoic acid is used. The chain hydrocarbon group may be straight-chained or branched-chained, and either saturated or unsaturated.

The group 13 element-containing halide includes, but is not particularly limited to, $BF_3$, $GaF_3$, $GaF$, $InF_3$, $InF$, $AlF_3$, $TlF_3$, $TlF$, $BCl_3$, $GaCl_3$, $GaCl$, $InCl_3$, $InCl$, $AlCl_3$, $TlCl_3$, $TlCl$, $BBr_3$, $GaBr_3$, $GaBr$, $InBr_3$, $InBr$, $AlBr_3$, $TlBr_3$, $TiB_R$, $BI_3$, $GaI_3$, $GaI$, $InI_3$, $InI$, $AlI_3$, $TlI_3$, $TlI$, or the like. Particularly, a group 13 element-containing iodide that is relatively stable from the standpoint of suppressing reaction with residual oxygen and with moisture is preferably used. For example, gallium iodide or indium iodide may be used.

For the modification organic compound, an organic compound including a nitrogen-containing functional group, a sulfur-containing functional group, an acidic group, an amide group, a phosphine group, a phosphine oxide group, a hydroxyl group or the like can be cited. Particularly, a modification organic compound containing a thiol group that is a sulfur-containing functional group is preferable by virtue of the strong bonding to the semiconductor nanoparticle and high surface protection effect. For a modification organic compound containing a thiol group, hexadecanethiol, dodecanethiol, octanethiol, or the like can be specifically cited.

In the relevant step, reaction is caused preferably under a condition in the presence of 1 to 6 of fatty acid salt to 1 of a group 13 element-containing halide (mole ratio). If the abundance of fatty acid exceeds 6 times that of the group 13 element-containing halide, the fatty acid will be excessive, leading to a tendency of the reaction being readily hindered by the presence of acid. If the abundance of fatty acid is below that of the group 13 element-containing halide, the halide becomes excessive. There will be a group 13 element-containing halide not dissolved in the solvent and not contributing to reaction, which is not favorable from the standpoint of cost.

The reaction condition in the fatty acid salt synthesis step may be set appropriately depending upon the combination of the used materials, the total amount of the raw material, the size and/or material of the reactor vessel employed, and the like. The reaction is preferably conducted in the temperature range of 50 to 200°C, more preferably 100 to 150°C. If the temperature is below 50°C, there is a tendency of difficulty in the progress of reaction. If the temperature exceeds 200°C, reaction will proceed too excessively, leading to a tendency of the chain hydrocarbon group of the fatty acid being readily destroyed, which is not preferable. Generally, the reaction time is approximately 1 to 5 hours.

The group 13 element-containing fatty acid salt obtained in the relevant step has the binding of a group 13 atom and a chain hydrocarbon group. A reaction scheme of causing a reaction using gallium iodide as the group 13 element-containing halide and using dodecanoic acid as the fatty acid will be exemplified in the following.

$$GaI_3 + 3CH_3(CH_2)_{10}COOH \rightarrow Ga(OCO(CH_2)_{10}CH_3)_3$$

[2] Core Formation Step

In the core formation step, a first solution including group 13 element-containing fatty acid salt, a group 13 element-containing halide, and alkali metal amide is heated to obtain a nanoparticle core made of a group 13 element-containing nitride. For the group 13 element-containing fatty acid salt, the salt obtained at the fatty acid salt synthesis step (1) described above may be used.

The heating of the first solution in the present step is preferably carried out in the temperature range of 100 to 400°C, more preferably in the temperature range of 150 to 300°C. If the heating temperature is below 100°C, there is a tendency of insufficient progress of crystallization. If the heating temperature exceeds 400°C, the chain hydrocarbon group in the group 13 element-containing fatty acid salt is readily destroyed, leading to a tendency that the desired chemical reaction does not proceed. The heating of the first solution may be carried out under a pressurized state by means of autoclaving or the like. The reaction time is generally 0.5 to 10 hours.

For the group 13 element-containing halide used in the present step, the group 13 element-containing halide exemplified in the fatty acid salt synthesis step [1] may be applied. Particularly, $GaCl_3$, $InCl_3$, $GaI_3$, and $InI_3$ are preferably used from the standpoint of reaction stability, raw material cost, and industrial utility of the eventually obtained semiconductor particle.

The alkali metal amide used in the present step includes, but not particularly limited to, sodium amide ($NaNH_2$), potassium amide ($KNH_2$), lithium amide ($LiNH_2$) lithium diethyl amide (($C_2H_5)_2NLi$), and the like. Particularly, sodium amide is preferably used in view of the efficient reaction with the group 13 element-containing fatty acid salt and group 13 element-containing halide.

The first solution used in the present step is prepared such that the group 13 element-containing fatty acid salt is 1 to 2 and the alkali metal amide is 5 to 30 to 1 of the group 13 element-containing halide (mole ratio), more preferably the group 13 element-containing fatty acid salt is 1 to 2 and the alkali metal amide is 10 to 25 to 1 of the group 13 element-containing halide (mole ratio). If the blended amount of alkali metal amide is below 5 times the amount of the group 13 element-containing halide, there is a tendency of the reaction being readily hindered since the alkali metal amide is not sufficient. If the blended amount of alkali metal amide exceeds 30 times that of the group 13 element-containing halide, and the blended amount of the group 13 element-containing fatty acid salt exceeds two times that of the group 13 element-containing halide, there is a tendency of the reaction being readily hindered since the amount of the group 13 element-containing fatty acid salt and the alkali metal amide is excessive, leading to a tendency of the reaction being readily hindered.

By causing a reaction of the group 13 element-containing fatty acid salt with the group 13 element-containing halide and alkali metal amide, a nanoparticle core including a group 13 element-containing nitride is formed. A reaction scheme of causing a reaction using gallium dodecanoate as the group 13 element-containing fatty acid salt, using indium iodide as the group 13 element-containing halide, and using sodium amide as the alkali metal amide will be exemplified in the following.

$$nGa(OCO(CH_2)_{10}CH_3)_3 + InI_3 + NaNH_2 \rightarrow InN/nGa(OCO(CH_2)_{10}CH_3)_3$$

As used herein, the notation of "A/B" in the present specification implies that A is covered with B. The notation of "A/B, C" implies that A is covered with B and C.

In the present step, by heating the group 13 element-containing halide and alkali metal amide in the presence of group 13 element-containing fatty acid salt, binding between the group 13 atom and nitrogen atom occurs to deposit a small particle made of a group 13 element-containing nitride (also referred to as "nanoparticle core" in the present specification). Since the group 13 element-containing fatty acid salt is present as a modification molecule simultaneous to the nucleus formation of the nanoparticle core, the group 13 element-containing fatty acid salt can be bound to the surface of the nanoparticle core efficiently. Furthermore, since the group 13 element-containing fatty acid salt is bound regularly to the nitrogen atoms at the nanoparticle core surface, a shell film can be formed evenly in the shell formation step [3] that will be described afterwards.

[3] Shell Formation Step

In the shell formation step, by heating a second solution including the nanoparticle core obtained at the core formation step [2], group 13 element-containing fatty acid salt and alkali metal amide, a semiconductor nanoparticle having the nanoparticle core covered with a shell layer made of a group 13 element-containing nitride is obtained. The nanoparticle core has the group 13 element-containing fatty acid salt bound at its surface, as described in the core formation step [2]. The second solution including additional group 13 element-containing fatty acid salt and alkali metal amide as well as the nanoparticle core is heated to cause reaction of the additional group 13 element-containing fatty acid salt and alkali metal amide at the surface of the nanoparticle core.

Although the group 13 element-containing fatty acid salt and alkali metal amide exemplified at the core formation step [2] may be used as the additional group 13 element-containing fatty acid salt and alkali metal amide used in the present step, the group 13 element-containing fatty acid salt and alkali metal amide used in the core formation step [2] and shell formation step [3] may be the same or different compounds. As to the group 13 element-containing fatty acid salt, the carbon number of the chain hydrocarbon group in the group 13 element-containing fatty acid salt used in the shell formation step [3]is preferably lower than that of the group 13 element-containing fatty acid salt used in the core formation step [2]. By using such group 13 element-containing fatty acid salt, shell formation is further facilitated to allow formation of a more even shell layer. This is probably because the reaction of the group 13 element-containing fatty acid salt and alkali metal amide newly added in the shell formation step [3] progresses in precedence at the surface of the nanoparticle core surface.

The heat treatment in the present step is carried out preferably in the temperature range of 100 to 400°C, more preferably 150 to 300°C. If the heating temperature is below 100°C, there is a tendency of insufficient progress of crystallization. If the heating temperature exceeds 400°C, the chain hydrocarbon group of the group 13 element-containing fatty acid salt is readily destroyed, leading to a tendency of the desired chemical reaction not progressing. The heat treatment may be carried out in a pressurized state by means of autoclaving or the like. The reaction time is generally 3 to 72 hours.

In the shell formation step, the additional group 13 element-containing fatty acid salt and alkali metal amide may be added in several stages to the nanoparticle core. Accordingly, the shell layer can be formed thick. As to the total amount of reaction in the present step, a reaction is preferably carried out such that the group 13 element-containing fatty acid salt is 1 to 3 and the alkali metal amide is 5 to 50 to 1 of the nanoparticle core (mole ratio), more preferably the group 13 element-containing fatty acid salt is 1 to 2 and the alkali metal amide is 10 to 30 to 1 of the nanoparticle core (mole ratio). If the group 13 element-containing fatty acid salt is below 1 and the alkali metal amide is below 5 to 1 of the nanoparticle core, the alkali metal amide will not be supplied sufficiently, leading to a tendency of the reaction readily being hindered. If the group 13 element-containing fatty acid salt exceeds 3 and the alkali metal amide exceeds 50 to 1 of the nanoparticle core, the group 13 element-containing fatty acid salt and alkali metal amide are so excessive that reaction is readily hindered, leading to a tendency of generating a shell layer of uneven thickness.

By the further reaction of the group 13 element-containing fatty acid salt and alkali metal amide with the nanoparticle core, a nanoparticle of a group 13 element-containing nitride of a core-shell structure is obtained. A reaction scheme of causing a reaction using gallium dodecanoate as the group 13 element-containing fatty acid salt and sodium amide as the alkali metal with a nanoparticle core having gallium dodecanoate bound to its surface will be exemplified in the following.

$$InN/nGa(OCO(CH_2)_{10}CH_3)_3 + Ga(OCO(CH_2)_{10}CH_3)_3 + NaNH_2 \rightarrow InN/GaN/nGa(OCO(CH_2)_{10}CH_3)_3$$

Since the group 13 element-containing fatty acid salt is present at the surface of the core particle as the modification molecule simultaneous to the nucleus formation of a crystal in the present shell formation step, there is the advantage that bonding at the surface is effected efficiently. There is also the advantage that the shell film can be formed evenly in the step of forming a shell film at the surface of the nanoparticle core since the group 13 element-containing fatty acid salt is bound regularly at the surface of the nanoparticle core.

[Semiconductor Nanoparticle]

The semiconductor nanoparticle of the present invention includes a crystallite including the binding of a group 13 element and a nitrogen atom, and group 13 element-containing fatty acid salt bound to the crystallite. The group 13 element-containing fatty acid salt is a modification molecule, chemically bound to the nitrogen atoms of the crystallite. The semiconductor nanoparticle of the present invention may be produced by the method of producing a semiconductor nanoparticle of the present invention set forth above, or by another method. Preferably, the semiconductor nanoparticle of the present invention is produced by the method of producing a semiconductor nanoparticle of the present invention set forth above.

The semiconductor nanoparticle of the present invention includes the binding of a group 13 atom that is at least one type selected from B, Al, Ga, In, and Tl, and a nitrogen atom. The binding of the 13 group atom and nitrogen atom can be confirmed by measuring the vibration energy of the chemical bond through infrared absorption (IR, FTIR method), or by measuring the chemical shift through the X-ray micro analyzer method (EPMA) or X-ray photoelectron spectroscopy (XPS).

The semiconductor nanoparticle of the present invention further includes the aforementioned modification organic compound. Preferably, the modification organic compound is chemically bound to the group 13 atom. A thiol compound is particularly preferable for the modification organic compound. Since the semiconductor nanoparticle of the present invention has the aforementioned modification organic compound chemically bound to a crystallite, i.e. anchored, high affinity is exhibited to an organic solvent (for example, pentane, normal hexane, toluene, xylene, benzene, chloroform, dichloromethane, ethylene glycol, hexamethylene glycol) and to an organic medium such as resin (for example, epoxy, acryl, silicon, phenol, polycarbonate, polypropylene, melamine, polyimide, polyamide). Further, the semiconductor nanoparticle of the present invention exhibits high dispersibility to the aforementioned organic solvent and resin by the anchorage of the modification organic compound. Moreover, since agglomeration of the semiconductor nanoparticles is prevented by the anchorage of the modification organic compound, the homogeneity of a filler, if based on such a semiconductor nanoparticle, will be improved.

Fig. 1 schematically represents an example of a basic structure of a semiconductor nanoparticle produced by the producing method of the present invention set forth above. As shown in Fig. 1, a semiconductor nanoparticle 10 includes a nanoparticle core 11, a shell layer 12 covering the surface of nanoparticle core 11, group 13 element-containing fatty acid salt 13 bound to the surface of shell layer 12, and a modification organic compound 14. Nanoparticle core 11 and shell layer 12 shown in Fig. 1 constitute the crystallite of the semiconductor nanoparticle of the present invention. A group 13 atom 13a and a chain hydrocarbon group 13b constitute group 13 element-containing fatty acid salt 13. Group 13 element-containing fatty acid salt 13 is fixed to the crystallite by the binding of group 13 atom 13a with a nitrogen atom of shell layer 12.

The semiconductor nanoparticle of the present invention may include an unintended impurity, and may have a group 2 element (Be, Mg, Ca, Sr, Ba), Zn, Si or the like intentionally added as a dopant as long as the concentration thereof is low. The concentration range is preferably $1 \times 10^{16}$ cm$^{-3}$ to $1 \times 10^{21}$ cm$^{-3}$, more preferably $1 \times 10^{17}$ cm$^{-3}$ to $1 \times 10^{19}$ cm$^{-3}$ from the standpoint of controlling the electrical property and optical property by a valence electron. As the particularly suitable dopant, Mg, Zn, and Si can be cited since they can readily act as a donor or acceptor generating an appropriate impurity level energy in the group 13 element-containing nitride.

The crystallite portion constituted of a group 13 element and nitrogen element in the semiconductor nanoparticle of the present invention may be a single composition particle formed of a single group 13 element and nitrogen element (for example, GaN, AlN, InN), or a mixed crystal grain constituted of a plurality of group 13 elements and nitrogen elements (for example, $In_xGa_{l-x}N$, $Al_xGa_{l-x}N$, $Al_xIn_yIGa_zN$ (where $0 < x < 1$, $0 < y < 1$, $x + y + z = 1$)). Similarly for a nanoparticle core and/or shell layer in the case of a semiconductor nanoparticle having a nanoparticle core and shell layer produced by the method of producing a semiconductor nanoparticle of the present invention, the crystal may be of a single composition constituted of a single group 13 element and nitrogen element, or a mixed crystal grain constituted of a plurality of group 13 elements and nitrogen elements.

[Phosphor]

A phosphor of the present invention employs the semiconductor nanoparticle of the present invention set forth above. Since the semiconductor nanoparticle of the present invention includes a crystallite including binding of a group 13 element and nitrogen atom, a group 13 element-containing fatty acid salt bound to the crystallite, and also a modification organic compound, the effect of covering a crystal defect at the surface of the particle is exhibited in addition to the above-described advantage of improving the dispersibility and affinity.

The semiconductor nanoparticle constituting the phosphor of the present invention forms a core-shell structure as described above. The shell may be made of two or more layers, in which case called a first shell, a second shell ... from the inner side. In this case, the innermost crystallite portion may function as the core, and the remaining portion including the modification molecule may function as respective shells sequentially towards the outer side.

The band gap of the nanoparticle core of the phosphor is preferably in the range of 1.8 to 2.8 eV, particularly in the range of 1.85 to 2.5 eV when used as a red phosphor, in the range of 2.3 to 2.5 eV when used as a green phosphor, and in the range of 2.65 to 2.8 eV when used as a blue phosphor. The band gap of the shell is preferably greater than that of the core. The aforementioned band gap can be adjusted to fall within the aforementioned ranges by taking a nanoparticle core based on mixed crystal grains constituted of a plurality of group 13 elements with the composition ratio of the group 13 element varied. The aforementioned band gap refers to a calculated value by converting the peak wavelength of the emission spectrum emitted by the phosphor based on the relevant nanoparticle into energy.

The particle size of the nanoparticle core of the semiconductor nanoparticle constituting the phosphor of the present invention is preferably in the range of 0.1 nm to 10 μm, particularly preferably in the range of 0.5 nm to 1 μm, more preferably in the range of 1 to 20 nm. If the particle size of the nanoparticle core is below 0.1 nm, there is a tendency of the band gap having an energy greater than that corresponding to visible luminescence and difficulty in control. If the particle size of the nanoparticle core exceeds 10 μm, light scattering at the surface of the phosphor becomes great, leading to a tendency of degradation in the property such as the light emitting efficiency. When the particle size of the nanoparticle core becomes less than or equal to two times the Bohr radius, the optical band gap will become larger due to the by the quantum size effect, in the phosphor of the present invention. The band gap is preferably in the range set forth above even in such a case. Adjustment may be carried out using both of the two control means set forth above.

EXAMPLES

The present invention will be described in further detail hereinafter based on, but not limited to the examples of the present invention and a comparative example.

[Example 1]

By reaction of 0.5 mmol of gallium iodide and 1.5 mmol of dodecanoic acid under heating at 120°C in 20 ml of 1-octadecene solution, 0.5 mmol of gallium dodecanoate solution was obtained (fatty acid salt synthesis step [1]).

Then, by adding 0.5 mmol of hexadecanethiol (HDT) to the gallium dodecanoate solution set forth above, and reaction of 0.5 mmol of indium iodide and 10 mmol of sodium amide under heating, a particle having the composition of "InN (nanoparticle core)/gallium dodecanoate (modification group 13 element-containing fatty acid salt), HDT (modification organic compound)" was produced (core formation step [2]).

By adding 0.5 mmol of gallium dodecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of "InN (nanoparticle core)/GaN(shell layer)/ gallium dodecanoate (modification group 13 element-containing fatty acid salt), HDT (modification organic compound)".

The semiconductor nanoparticle produced according to the present example is a semiconductor nanoparticle 10 having the composition of "InN (nanoparticle core 11)/GaN (shell layer 12)/gallium dodecanoate (group 13 element-containing fatty acid salt 13), HDT (modification organic compound 14)", as shown in Fig. 1.

As a result of measurement of the obtained semiconductor nanoparticle 10 through X-ray diffraction, the average particle size (diameter) of the nanoparticle core calculated by the spectral full width at half maximum was 5 nm. For the calculation of the average particle size of the nanoparticle core, the Scherrer equation (Equation (1)) set forth below was used:

$$B = \lambda/\cos\theta \cdot R \qquad \qquad ... (1)$$

where B: X-ray full width at half maximum [deg]; λ: X-ray wavelength [nm]; θ: Bragg angle [deg]; and R: particle size [nm].

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The InN crystal constituting the nanoparticle core could exhibit red light emission since the particle size is adjusted such that the light emission wavelength is 620 nm.

With regard to the phosphor made of the semiconductor nanoparticle of Example 1, the light emitting intensity of light having a wavelength of 620 nm was measured using a spectrofluorometer (product name: Fluoromax 3 (product of Horiba, product of Jobin Yvon)). A high light emitting intensity of 80 a. u. (arbitrary unit) was observed.

It was therefore appreciated that the semiconductor nanoparticle produced according to the producing method of Example 1 exhibited a quantum size effect, and had high light emitting intensity. This is probably due to the fact that, by forming the nanoparticle core using a group 13 element-containing fatty acid salt, an even shell film can be formed in the shell formation step since the group 13 element-containing fatty acid salt that is the shell raw material or a group 13 element-containing fatty acid salt that is substituted efficiently for the group 13 element-containing fatty acid salt that is the shell material can be bound to the core surface. Further, it is probably due to the fact that the surface defect of the semiconductor nanoparticle was capped stably by the coverage using a thiol compound. It was also appreciated that semiconductor nanoparticles of Example 1 do not agglomerate with each other, have an even size, and high dispersibility. This is probably due to the repelling force generated between the group 13 element-containing fatty acid salt and modification organic compound that are bound at each semiconductor nanoparticle by the even coverage of the group 13 element-containing fatty acid salt and modification organic compound on the surface of the semiconductor crystallite, and control of the particle size of the semiconductor nanoparticle through the group 13 element-containing fatty acid salt and modification organic compound.

[Example 2]

By a reaction of 0.5 mmol of indium iodide and 1.5 mmol of dodecanoic acid under heating at 120°C in 20 ml of 1-octadecene solution, 0.5 mmol of indium dodecanoate solution was obtained (fatty acid salt synthesis step [1]).

Then, by adding 0.5 mmol of dodecanethiol (DDT) to the indium dodecanoate solution set forth above, and a reaction of 0.5 mmol indium iodide and 10 mmol of sodium amide under heating, a particle having the composition of "InN (nanoparticle core)/indium dodecanoate (modification group 13 element-containing fatty acid salt), DDT (modification organic compound)" was produced (core formation step [2]).

By adding 0.5 mmol of gallium dodecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of "InN (nanoparticle core)/GaN(shell layer)/indium dodecanoate and gallium dodecanoate (modification group 13 element-containing fatty acid salt), DDT (modification organic compound)" (shell formation step [3]).

As a result of measurement of the obtained semiconductor nanoparticle through X-ray diffraction, the average particle size (diameter) of the nanoparticle core calculated by the spectral full width at half maximum was 4 nm. For the calculation of the average particle size of the nanoparticle core, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The InN crystal constituting the nanoparticle core could exhibit green light emission since the particle size was adjusted such that the light emission wavelength is 520 nm.

With regard to the phosphor made of the semiconductor nanoparticle of Example 2, the light emitting intensity of light having a wavelength of 520 nm was measured using a spectrofluorometer (product name: Fluoromax 3 (product of Horiba, product of Jobin Yvon)). A high light emitting intensity of 70 a. u. (arbitrary unit) was observed.

It was therefore appreciated that the semiconductor nanoparticle produced according to the producing method of Example 2 exhibited a quantum size effect, and had high light emitting intensity. This is probably because the synthesis using the group 13 element-containing fatty acid salt at the stage of synthesizing a nanoparticle core allows indium dodecanoate to be bound at the core surface, enabling substitution with the gallium dodecanoate efficiently at the time of shell formation, leading to formation of an even GaN shell film. Further, it is probably due to the fact that the surface defect of the semiconductor nanoparticle was capped stably by the coverage using dodecanethiol. It was also appreciated that semiconductor nanoparticles of Example 2 do not agglomerate with each other, have an even size, and high dispersibility. This is probably due to the repelling force generated between the group 13 element-containing fatty acid salt and modification organic compound that are bound at each semiconductor crystallite by the even coverage of the group 13 element-containing fatty acid salt and modification organic compound on the surface of the semiconductor crystal, and control of the particle size of the semiconductor nanoparticle through the modification group 13 element-containing fatty acid salt and modification organic compound.

[Example 3]

By a reaction of 0.5 mmol of gallium iodide and 1.5 mmol of dodecanoic acid under heating at 120°C in 20 ml of 1-octadecene solution, 0.5 mmol of gallium octadecanoate solution was obtained (fatty acid salt synthesis step [1]).

Then, by adding 0.5 mmol of HDT to the gallium octadecanoate solution set forth above, and a reaction of 0.5 mmol indium iodide and 10 mmol of sodium amide under heating, a particle having the composition of "InN (nanoparticle core)/ gallium octadecanoate (modification group 13 element-containing fatty acid salt), HDT (modification organic compound)" was produced (core formation step [2]).

By adding 0.5 mmol of gallium dodecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of "InN (nanoparticle core)/GaN(shell layer)/ gallium octadecanoate and gallium dodecanoate (modification group 13 element-containing fatty acid salt), HDT (modification organic compound)" (shell formation step [3]).

As a result of measurement of the obtained semiconductor nanoparticle through X-ray diffraction, the average particle size (diameter) of the nanoparticle core calculated by the spectral full width at half maximum was 3 nm. For the calculation of the average particle size of the nanoparticle core, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The InN crystal constituting the nanoparticle core could exhibit green light emission since the particle size was adjusted such that the light emission wavelength is 470 nm.

With regard to the phosphor made of the semiconductor nanoparticle of Example 3, the light emitting intensity of light having a wavelength of 470 nm was measured using a spectrofluorometer (product name: Fluoromax 3 (product of Horiba, product of Jobin Yvon)). A high light emitting intensity of 95 a. u. (arbitrary unit) was observed.

It was therefore appreciated that the semiconductor nanoparticle produced according to the producing method of Example 3 exhibited a quantum size effect, and had high light emitting intensity. This is probably because the synthesis using the group 13 element-containing fatty acid salt at the stage of synthesizing a nanoparticle core allows gallium octadecanoate to be bound at the core surface, enabling efficient substitution with the gallium dodecanoate having a short chain hydrocarbon group at the time of shell formation, leading to formation of an even GaN shell film. Further, it is probably due to the fact that the surface defect of the semiconductor nanoparticle was capped stably by the coverage using HDT.

It was also appreciated that semiconductor nanoparticles of Example 3 do not agglomerate with each other, have an even size, and high dispersibility. This is probably due to the repelling force generated between the group 13 element-containing fatty acid salt and modification organic compound that are bound at each semiconductor nanoparticle by the even coverage of the modification group 13 element-containing fatty acid salt and modification organic compound on the surface of the semiconductor crystallite, and control of the particle size of the semiconductor nanoparticle through the group 13 element-containing fatty acid salt and modification organic compound.

[Example 4]

By a reaction of 0.5 mmol of gallium iodide and 1.5 mmol of tetradecanoic acid under heating at 120°C in 20 ml of 1-octadecene solution, 0.5 mmol of gallium tetradecanoate solution was obtained (fatty acid salt synthesis step [1]).

Then, by adding 0.5 mmol of octanethiol (OT) to the gallium tetradecanoate solution set forth above, and a reaction of 0.15 mmol of indium iodide, 0.35 mmol of gallium iodide and 10 mmol of sodium amide, and reaction under heating, a particle having the composition of $In_{0.3}Ga_{0.7}N$ (nanoparticle core) gallium tetradecanoate (modification group 13 element-containing fatty acid salt), OT (modification organic compound)" was produced (core formation step [2]).

By adding 0.5 mmol of gallium octadecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of $In_{0.3}Ga_{0.7}N$ (nanoparticle core)/GaN(shell layer)/ gallium tetradecanoate and gallium octadecanoate (modification group 13 element-containing fatty acid salt), OT (modification organic compound)" (shell formation step [3]).

As a result of measurement of the phosphor made of the obtained semiconductor nanoparticle through X-ray diffraction, the average particle size (diameter) of the nanoparticle core calculated by the spectral full width at half maximum was 5 nm. For the calculation of the average particle size of the semiconductor nanoparticle, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The $In_{0.3}Ga_{0.7}N$ crystal constituting the nanoparticle core could exhibit blue light emission since the composition ratio of the group 13 mixed crystal grains and particle size were adjusted such that the light emission wavelength is 470 nm.

With regard to the phosphor made of the semiconductor nanoparticle of Example 4, the light emitting intensity of light having a wavelength of 480 nm was measured using a spectrofluorometer (product name: Fluoromax 3 (product of Horiba, product of Jobin Yvon)). A high light emitting intensity of 75 a. u. (arbitrary unit) was observed.

It was therefore appreciated that the semiconductor nanoparticle produced according to the producing method of Example 4 exhibited a quantum size effect, and had high light emitting intensity. This is probably because the synthesis using the group 13 element-containing fatty acid salt at the stage of synthesizing a nanoparticle core allows gallium tetradecanoate to be bound at the core surface, and enabling substitution with the gallium octadecanoate having a long chain hydrocarbon group with reduction in the efficiency suppressed at the time of shell formation, leading to formation of an even GaN shell film. Further, it is probably due to the fact that the surface defect of the semiconductor nanoparticle was capped stably by the coverage using octanethiol.

It was also appreciated that semiconductor nanoparticles of Example 4 do not agglomerate with each other, have an even size, and high dispersibility. This is probably due to the repelling force generated between the group 13 element-containing fatty acid salt and modification organic compound that are bound at each semiconductor nanoparticle by the even coverage of the group 13 element-containing fatty acid salt and modification organic compound on the surface of the semiconductor crystallite, and control of the particle size of the semiconductor nanoparticle phosphor through the group 13 element-containing fatty acid salt and modification organic compound.

[Example 5]

By a reaction of 0.5 mmol of gallium iodide and 1.5 mmol of hexadecanoic acid under heating at 120°C in 20 ml of 1-octadecene solution, 0.5 mmol of gallium hexadecanoate solution was obtained (fatty acid salt synthesis step [1]).

Then, by adding 0.5 mmol of DDT to the gallium hexadecanoate solution set forth above, and a reaction of 0.2 mmol of indium iodide, 0.3 mmol of gallium iodide and 10 mmol of sodium amide under heating, a particle having the composition of" $In_{0.4}Ga_{0.6}N$ (nanoparticle core)/ gallium hexadecanoate (modification group 13 element-containing fatty acid salt), DDT (modification organic compound)" was produced (core formation step [2]).

By adding 0.5 mmol of gallium tetradecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of "$In_{0.4}Ga_{0.6}N$(nanoparticle core)/GaN(shell layer)/ gallium haxadecanoate and gallium tetradecanoate (modification group 13 element-containing fatty acid salt), DDT (modification organic compound)" (shell formation step [3]).

As a result of measurement of the phosphor made of the obtained semiconductor nanoparticle through X-ray diffraction, the average particle size (diameter) of the nanoparticle core calculated by the spectral full width at half maximum was 5 nm. For the calculation of the average particle size of the semiconductor nanoparticle, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The $In_{0.4}Ga_{0.6}N$ crystal constituting the nanoparticle core could exhibit green light emission since the composition ratio of the group 13 mixed crystal grains and particle size were adjusted such that the light emission wavelength is 520 nm.

With regard to the phosphor made of the semiconductor nanoparticle of Example 5, the light emitting intensity of light having a wavelength of 520 nm was measured using a spectrofluorometer (product name: Fluoromax 3 (product of Horiba, product of Jobin Yvon)). A high light emitting intensity of 90 a. u. (arbitrary unit) was observed.

It was therefore appreciated that the semiconductor nanoparticle produced according to the producing method of Example 5 exhibited a quantum size effect, and had high light emitting intensity. This is probably because the synthesis using the group 13 element-containing fatty acid salt at the stage of synthesizing a nanoparticle core allows gallium hexadecanoate to be bound at the core surface, and enabling efficient substitution with the gallium tetradecanoate having a short chain hydrocarbon group at the time of shell formation, leading to formation of an even GaN shell film. Further, it is probably due to the fact that the surface defect of the semiconductor nanoparticle was capped stably by the coverage using dodecanethiol.

It was also appreciated that semiconductor nanoparticles of Example 5 do not agglomerate with each other, have an even size, and high dispersibility. This is probably due to the repelling force generated between the group 13 element-containing fatty acid salt and modification organic compound that are bound at each semiconductor nanoparticle by the even coverage of the group 13 element-containing fatty acid salt and modification organic compound on the surface of the semiconductor crystallite, and control of the particle size of the semiconductor nanoparticle phosphor through the group 13 element-containing fatty acid salt and modification organic compound.

[Example 6]

By a reaction of 0.5 mmol of gallium iodide and 1.5 mmol of octadecanoic acid under heating at 120°C in 20 ml of 1-octadecene solution, 0.5 mmol of gallium octadecanoate solution was obtained (fatty acid salt synthesis step [1]).

Then, by a reaction of 0.5 mmol of indium iodide and 10 mmol of sodium amide with the gallium octadecanoate solution set forth above under heating, a particle having the composition of "InN (nanoparticle core)/ gallium octadecanoate (modification group 13 element-containing fatty acid salt)" was produced (core formation step [2]).

By adding 0.5 mmol of gallium dodecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of "InN (nanoparticle core)/GaN(shell layer)/ gallium octadecanoate and gallium dodecanoate (modification group 13 element-containing fatty acid salt)" (shell formation step [3]).

As a result of measurement of the obtained semiconductor nanoparticle phosphor through X-ray diffraction, the average particle size (diameter) of the nanoparticle core calculated by the spectral full width at half maximum was 5 nm. For the calculation of the average particle size of the nanoparticle core, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The InN crystal constituting the nanoparticle core could exhibit red light emission since the particle size was adjusted such that the light emission wavelength is 620 nm.

With regard to the phosphor made of the semiconductor nanoparticle of Example 6, the light emitting intensity of light having a wavelength of 620 nm was measured using a spectrofluorometer (product name: Fluoromax 3 (product of Horiba, product of Jobin Yvon)). A high light emitting intensity of 70 a. u. (arbitrary unit) was observed.

It was therefore appreciated that the semiconductor nanoparticle produced according to the producing method of Example 6 exhibited a quantum size effect, and had high light emitting intensity. This is probably because the synthesis using the group 13 element-containing fatty acid salt at the stage of synthesizing a nanoparticle core allows gallium octadecanoate to be bound at the core surface, enabling efficient substitution with the gallium dodecanoate having a short chain hydrocarbon group at the time of shell formation, leading to formation of an even GaN shell film.

It was also appreciated that semiconductor nanoparticles of Example 6 do not agglomerate with each other, have an even size, and high dispersibility. This is probably due to the repelling force generated between the group 13 element-containing fatty acid salt bound at each semiconductor nanoparticle by the even coverage of the group 13 element-containing fatty acid salt on the surface of the semiconductor crystallite, and control of the particle size of the semiconductor nanoparticle phosphor.

[Example 7]

By a reaction of 0.5 mmol of gallium iodide and 1.5 mmol of octadecanoic acid under heating at 120°C in 20 ml of 1-octadecene solution, 0.5 mmol of gallium octadecanoate solution was obtained (fatty acid salt synthesis step [1]).

Then, by adding 0.5 mmol of HDT to the gallium octadecanoate solution set forth above, and a reaction of 0.5 mmol of indium iodide, and 10 mmol of sodium amide under heating, a particle having the composition of "InN (nanoparticle core)/gallium octadecanoate (modification group 13 element-containing fatty acid salt), HDT (modification organic compound)" was produced (core formation step [2]).

By adding 0.5 mmol of gallium dodecanoate and 10 mmol of sodium amide obtained in a manner similar to that of the fatty acid salt synthesis step [1] set forth above to the aforementioned nanoparticle core solution for reaction under heating, there was produced a semiconductor nanoparticle of a core-shell structure having the composition of "InN (nanoparticle core)/GaN(shell layer)/ gallium octadecanoate and gallium dodecanoate (modification group 13 element-containing fatty acid salt), HDT (modification organic compound)" (shell formation step [3] first time).

Further, by adding 0.5 mmol of gallium dodecanoate and 10 mmol of sodium amide obtained in a manner similar to that of the fatty acid salt synthesis step [1] set forth above to the aforementioned semiconductor nanoparticle solution of the core-shell structure for reaction under heating, there was produced a semiconductor nanoparticle of a core-shell structure having the composition of "InN (nanoparticle core)/GaN(shell layer)/ gallium octadecanoate and gallium dodecanoate (modification group 13 element-containing fatty acid salt), HDT (modification organic compound)" (shell formation step [3] second time).

As a result of measurement of the phosphor made of the obtained semiconductor nanoparticle through X-ray diffraction, the average particle size (diameter) of the nanoparticle core calculated by the spectral full width at half maximum was 5 nm. For the calculation of the average particle size of the semiconductor nanoparticle, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The InN crystal constituting the nanoparticle core could exhibit red light emission since the composition ratio of the group 13 mixed crystal grains and particle size were adjusted such that the light emission wavelength is 620 nm.

With regard to the phosphor made of the semiconductor nanoparticle of Example 7, the light emitting intensity of light having a wavelength of 480 nm was measured using a spectrofluorometer (product name: Fluoromax 3 (product of Horiba, product of Jobin Yvon)). A high light emitting intensity of 100 a. u. (arbitrary unit) was observed. It was therefore appreciated that the semiconductor nanoparticle produced according to the producing method of Example 7 exhibited a quantum size effect, and had high light emitting intensity. This is probably because the synthesis using the group 13 element-containing fatty acid salt at the stage of synthesizing a nanoparticle core allows gallium octadecanoate to be bound at the core surface, and enabling efficient substitution with the gallium dodecanoate having a short chain hydrocarbon group at the time of shell formation, leading to formation of an even GaN shell film. Further, it is probably due to the fact that the surface defect of the semiconductor nanoparticle was capped stably by the coverage using hexadecanethiol.

It was also appreciated that semiconductor nanoparticles of Example 4 do not agglomerate with each other, have an even size, and high dispersibility. This is probably due to the repelling force generated between the group 13 element-containing fatty acid salt and modification organic compound that are bound at each semiconductor nanoparticle by the even coverage of the group 13 element-containing fatty acid salt and modification organic compound on the surface of the semiconductor crystallite, and control of the particle size of the semiconductor nanoparticle phosphor through the group 13 element-containing fatty acid salt and modification organic compound.

[Comparative Example]

By the reaction under heating of 0.5 mmol of indium chloride and 0.5 mmol of lithium nitride in 20 ml of 1-octadecene solution added with 0.5 mmol of trioctyl amine (TOA), a particle having a composition of "InN (nanoparticle core)/TOA (modification organic compound)" was produced.

By a reaction under heating with 0.5 mmol of gallium chloride and 0.5 mmol of lithium nitride added into the nanoparticle core solution set forth above, a semiconductor nanoparticle of a core-shell structure having a composition of "InN (nanoparticle core)/GaN (shell layer)/TOA (modification organic compound)" was produced.

As a result of measurement of the phosphor made of the obtained semiconductor nanoparticle through X-ray diffraction, the average particle size (diameter) of the nanoparticle core calculated by the spectral full width at half maximum was 5 nm. For the calculation of the average particle size of the semiconductor nanoparticle, the Scherrer equation (Equation (1)) was used.

The obtained semiconductor nanoparticle absorbed the excitation light source. The excited light energy exhibited transition between the ground level of the conduction band and the ground level of the valence band. The semiconductor nanoparticle can be used as a phosphor emitting light of a wavelength corresponding to the aforementioned energy. Specifically, a blue light-emitting element formed of a group 13 element-containing nitride can be used as the excitation light source. Particularly, light emission of 405 nm having high external quantum efficiency could be absorbed efficiently. The InN crystal constituting the nanoparticle core could exhibit red light emission since the particle size was adjusted such that the light emission wavelength is 620 nm.

With regard to the phosphor made of the semiconductor nanoparticle of Comparative Example 1, the light emitting intensity of light having a wavelength of 620 nm was measured using a spectrofluorometer (product name: Fluoromax 3 (product of Horiba, product of Jobin Yvon)). A light emitting intensity of 20 a. u. (arbitrary unit) was observed. Although the semiconductor nanoparticle produced by the producing method of Comparative Example 1 exhibited a quantum size effect, the group 13 element-containing fatty acid salt could not be bound to the core surface since synthesis using a group 13 element-containing fatty acid salt was not carried out in the synthesis of the nanoparticle core, disallowing formation of an even shell film in the shell formation step. It is therefore considered that the light emitting intensity was degraded.

Table 1 set forth below summarizes the above-described measured results related to semiconductor nanoparticles produced according to the producing method of Examples 1-7 and Comparative Example 1.

Table 1

| | Nanoparticle core | Shell layer | Group 13 element-containing fatty acid salt (core formation step) | Group 13 element-containing fatty acid salt (shell formation step) | Modification organic compound | Nanoparticle core particle size (nm) | Light emission wavelength (nm) | Light emitting intensity (a. u.) |
|---|---|---|---|---|---|---|---|---|
| Example 1 | InN | GaN | gallium dodecanoate | gallium dodecanoate | hexadecanethiol | 5 | 620 | 80 |
| Example 2 | InN | GaN | indium dodecanoate | gallium dodecanoate | dodecanethiol | 4 | 520 | 70 |
| Example 3 | InN | GaN | gallium octadecanoate | gallium dodecanoate | hexadecanethiol | 3 | 470 | 95 |
| Example 4 | $In_{0.3}Ga_{0.7}N$ | GaN | gallium tetradecanoate | gallium octadecanoate | octanethiol | 5 | 480 | 75 |
| Example 5 | $In_{0.4}Ga_{0.6}N$ | GaN | gallium hexadecanoate | gallium tetradecanoate | dodecanethiol | 5 | 520 | 90 |
| Example 6 | InN | GaN | gallium octadecanoate | gallium dodecanoate | | 5 | 620 | 70 |
| Example 7 | InN | GaN (thick film) | gallium octadecanoate | gallium dodecanoate | hexadecanethiol | 5 | 620 | 100 |
| Comparative Example 1 | InN | GaN | | | trioctyl amine | 5 | 620 | 20 |

It should be understood that the embodiments and examples disclosed herein are illustrative and non-restrictive in every respect. The scope of the present invention is defined by the terms of the claims, rather than the description above, and is intended to include any modification within the scope and meaning equivalent to the terms of the claims.

**Claims**

1. A method of producing a semiconductor nanoparticle, comprising:

   a core formation step of heating a first solution including group 13 element-containing fatty acid salt, a group 13 element-containing halide, and alkali metal amide to obtain a nanoparticle core made of a group 13 element-containig nitride, and
   a shell formation step of heating a second solution including said nanoparticle core, group 13 element-containing fatty acid salt, and alkali metal amide to obtain a semiconductor nanoparticle (10) having said nanoparticle core (11) covered with a shell layer (12) made of a group 13 element-containing nitride.

2. The method of producing a semiconductor nanoparticle according to claim 1, further comprising a fatty acid salt synthesis step of causing a reaction between a group 13 element-containing halide and fatty acid to obtain said group 13 element-containing fatty acid salt.

3. The method of producing a semiconductor nanoparticle according to claim 1, wherein said first solution further includes a modification organic compound.

4. The method of producing a semiconductor nanoparticle according to claim 3, wherein said modification organic compound is a thiol compound.

5. The method of producing a semiconductor nanoparticle according to claim 4, wherein said thiol compound is hexadecanethiol.

6. The method of producing a semiconductor nanoparticle according to claim 1, wherein said group 13 element-containing halide is gallium iodide and/or indium iodide.

7. The method of producing a semiconductor nanoparticle according to claim 1, wherein said alkali metal amide is sodium amide.

8. The method of producing a semiconductor nanoparticle according to claim 1, wherein said fatty acid salt includes a chain hydrocarbon group having a carbon number greater than or equal to 8.

9. The method of producing a semiconductor nanoparticle according to claim 8, wherein said fatty acid salt in said first solution and said fatty acid salt in said second solution are different compounds.

10. The method of producing a semiconductor nanoparticle according to claim 9, wherein said fatty acid salt in said second solution includes a chain hydrocarbon group of a carbon number smaller than the carbon number of said fatty acid salt in said first solution.

11. A semiconductor nanoparticle (10) comprising:

    a crystallite including binding of a group 13 atom and a nitrogen atom, and
    a group 13 element-containing fatty acid salt (13),
    said nitrogen atom in said crystallite and a group 13 atom (13b) in said group 13 element-containing fatty acid salt being chemically bound.

12. The semiconductor nanoparticle (10) according to claim 11, further comprising a thiol compound (14),
    said group 13 atom of said crystallite and said thiol compound (14) being chemically bound.

13. A phosphor employing the semiconductor nanoparticle defined in claim 11.

FIG.1

Europäisches
Patentamt

European
Patent Office

Office européen
des brevets

**EUROPEAN SEARCH REPORT**

Application Number

EP 12 16 8956

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | GB 2 467 162 A (SHARP KK [JP]) 28 July 2010 (2010-07-28) * page 7; example 1 * ----- | 1,11,13 | INV. C01B21/06 C30B7/00 C30B29/60 C09K11/02 C30B29/40 |
| A | GB 2 467 161 A (SHARP KK [JP]) 28 July 2010 (2010-07-28) * page 10 - page 12 * ----- | 1,11,13 | |
| A | WO 2006/134599 A1 (YISSUM RES DEV CO [IL]; BANIN URI [IL]; AHARONI ASSAF [IL]) 21 December 2006 (2006-12-21) * the whole document * ----- | 1,11 | |
| A | US 2010/193767 A1 (NAASANI IMAD [GB] ET AL) 5 August 2010 (2010-08-05) * claim 1 * ----- | 1 | |
| A | US 2008/173845 A1 (RYOWA TATSUYA [JP] ET AL) 24 July 2008 (2008-07-24) * claims 1,9 * ----- | 1,11,13 | |
| A,D | C. B. MURRAY ET AL: "Synthesis and characterization of nearly monodisperse CdE (E = sulfur, selenium, tellurium) semiconductor nanocrystallites", JOURNAL OF THE AMERICAN CHEMICAL SOCIETY, vol. 115, no. 19, 1 September 1993 (1993-09-01), pages 8706-8715, XP55022108, ISSN: 0002-7863, DOI: 10.1021/ja00072a025 * the whole document * ----- | 1 | TECHNICAL FIELDS SEARCHED (IPC) C30B B82Y C01B C09K |

The present search report has been drawn up for all claims

| Place of search | Date of completion of the search | Examiner |
|---|---|---|
| The Hague | 22 August 2012 | Cook, Steven |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**EP 2 530 048 A1**

## ANNEX TO THE EUROPEAN SEARCH REPORT
## ON EUROPEAN PATENT APPLICATION NO.

EP 12 16 8956

This annex lists the patent family members relating to the patent documents cited in the above-mentioned European search report.
The members are as contained in the European Patent Office EDP file on
The European Patent Office is in no way liable for these particulars which are merely given for the purpose of information.

22-08-2012

| Patent document cited in search report | | Publication date | Patent family member(s) | | Publication date |
|---|---|---|---|---|---|
| GB 2467162 | A | 28-07-2010 | CN | 102292410 A | 21-12-2011 |
| | | | GB | 2467162 A | 28-07-2010 |
| | | | US | 2012018774 A1 | 26-01-2012 |
| | | | WO | 2010085001 A1 | 29-07-2010 |
| GB 2467161 | A | 28-07-2010 | CN | 102292411 A | 21-12-2011 |
| | | | GB | 2467161 A | 28-07-2010 |
| | | | US | 2011272668 A1 | 10-11-2011 |
| | | | WO | 2010085002 A1 | 29-07-2010 |
| WO 2006134599 | A1 | 21-12-2006 | AT | 520156 T | 15-08-2011 |
| | | | CN | 101194372 A | 04-06-2008 |
| | | | EP | 1891686 A1 | 27-02-2008 |
| | | | JP | 2008544013 A | 04-12-2008 |
| | | | KR | 20080046158 A | 26-05-2008 |
| | | | US | 2009230382 A1 | 17-09-2009 |
| | | | US | 2011212561 A1 | 01-09-2011 |
| | | | WO | 2006134599 A1 | 21-12-2006 |
| US 2010193767 | A1 | 05-08-2010 | AU | 2010212184 A1 | 01-09-2011 |
| | | | CA | 2751465 A1 | 12-08-2010 |
| | | | CN | 102365549 A | 29-02-2012 |
| | | | EP | 2394169 A1 | 14-12-2011 |
| | | | KR | 20110127159 A | 24-11-2011 |
| | | | TW | 201035036 A | 01-10-2010 |
| | | | US | 2010193767 A1 | 05-08-2010 |
| | | | WO | 2010089545 A1 | 12-08-2010 |
| US 2008173845 | A1 | 24-07-2008 | CN | 101161766 A | 16-04-2008 |
| | | | JP | 4318710 B2 | 26-08-2009 |
| | | | JP | 2008094968 A | 24-04-2008 |
| | | | KR | 20080033112 A | 16-04-2008 |
| | | | US | 2008173845 A1 | 24-07-2008 |

EPO FORM P0459

For more details about this annex : see Official Journal of the European Patent Office, No. 12/82

18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011121970 A

- JP 2008544013 A

**Non-patent literature cited in the description**

- **C. B. MURRAY et al.** *Journal of the American Chemical Society,* 1993, vol. 115, 8706-8715